# EUROPEAN PATENT SPECIFICATION

(11) **EP 0 403 075 B1**
(45) Date of publication and mention of the grant of the patent: **17.04.1996**
(21) Application number: 90305145.6
(22) Date of filing: 14.05.1990
(51) Int. Cl.: H03K 19/173, H03K 19/20, H03K 19/094, H03K 19/0944

(54) **High performance bicmos logic circuit with full output voltage swing**
BICMOS-Hochleistungsschaltkreis mit voller Ausgangsspannungsschwingung
Circuit logique BICMOS à haut rendement avec oscillation complète de la tension de sortie

(30) Priority: 15.05.1989 US 352588
(43) Date of publication of application: 19.12.1990
(73) Proprietor: TEXAS INSTRUMENTS INCORPORATED, Dallas Texas 75265 (US)
(72) Inventor: Chau, Kwok K., Dallas, Texas 75240 (US); Gallia, James D., Dallas, Texas 75231 (US); Shah, Ashwin H., Dallas, Texas 75243 (US)
(74) Representative: Abbott, David John

(56) References cited:
- EP-A- 0 220 856
- EP-A- 0 304 035
- EP-A- 0 317 430
- US-A- 4 694 203
- US-A- 4 733 110
- US-A- 4 734 597
- US-A- 4 769 561
- US-A- 4 804 869
- PATENT ABSTRACTS OF JAPAN, Vol 8, No. 88, (E-240), [1525] for JP-A-59 008 431

## Description

### BACKGROUND OF THE INVENTION

It is desirable to have logic circuits which provide high speed operation yet consume very little power. A circuit exhibiting these properties would greatly enhance extremely fast Until now, no circuits microprocessors and computer systems. Until now, no circuits capable of optimized speed within constraints of low power consumption have existed which are suitable to meet the demands dictated by today's electronic environment.

In JP-A-59-008431 there is described a non-inverting buffer circuit having MOS transistors driving two series connected bipolar transistors having the output node connected to their junction. The MOS transistors comprise two CMOS pairs respectively connected in complementary manner from collector to emitter in parallel with the bipolar transistors with the outputs of the CMOS pairs respectively connected to the bases of the bipolar transistors. The input node is connected to the gates of all four MOS transistors which serve to connect the base to the collector of one bipolar transistor and the base to the emitter of the other bipolar transistors so that the voltage at the output node repeats the logic level applied to the input node.

In US-A-4 769 561 there is described a logic circuit of similar construction to the buffer of JP-A-59-008431 having MOS transistors driving two series connected bipolar transistors having the output node connected to their junction. The MOS transistors are in series and parallel connected pairs according to the logic to be implemented for feeding differentially currents to the bases of the bipolar transistors and to discharge the base of the upper bipolar transistor. The base of the lower transistor is selectively discharged by a single MOS transistor controlled by the voltage at a suitable node.

US-A-4 804 869 describes a similar circuit to US-A-4 769 561 with the difference that the bases of both of the bipolar transistors are selectively discharged by single MOS transistors each controlled by the voltage at the base of the other bipolar transistor.

### OBJECTS OF THE INVENTION

It is an object of the invention to provide a new and improved logic circuit.

It is another object of the invention to provide a new and improved logic circuit capable of high speed operation and low power consumption.

These and other objects of the invention, together with the features and advantages thereof, will become apparent from the following detailed specification when read together with the accompanying drawings in which applicable reference numerals and symbols have been carried forward.

### SUMMARY OF THE INVENTION

According to a first aspect of the present invention there is provided a circuit comprising:
a first bipolar transistor having a collector connected to a first reference potential, a base and an emitter connected to an output terminal;
a second bipolar transistor having a collector connected to said output terminal, a base and an emitter connected to a second reference potential;
a first field effect transistor having a first current handling terminal connected to said first reference potential, a second current handling terminal connected to said base of said first bipolar transistor and having a gate connected to an input terminal;
a second field effect transistor having a gate connected to said input terminal and first and second current handling terminals interposed between said output terminal and said base of said second bipolar transistor;
a third field effect transistor having a first current handling terminal connected to said base of said first bipolar transistor, a second current handling terminal connected to said output terminal and a gate characterized in that sais gate of said third field effect transistor is connected to said second reference potential.

According to a second aspect of the present invention there is provided a circuit comprising:
a first bipolar transistor having a collector connected to a first reference potential, a base and an emitter connected to an output terminal;
a second bipolar transistor having a collector connected to said output terminal, a base and an emitter connected to a second reference potential;
a first field effect transistor having a first current handling terminal connected to said first reference potential, a second current handling terminal connected to said base of said first bipolar transistor and having a gate connected to an input terminal;
a second field effect transistor having a gate connected to said input terminal and first and second current handling terminals interposed between said output terminal and said base of said second bipolar transistor;
a third field effect transistor having a first current handling terminal connected to said base of said first bipolar transistor, a second current handling terminal connected to said output terminal and a gate;
characterized in that said circuit further comprises:
   an inverter having an input connected to said output terminal and an output connected to said gate of said third field effect transistor.

### BRIEF DESCRIPTION OF THE DRAWINGS

Figure 1 illustrates a schematic drawing of a first preferred embodiment of the invention.

Figure 2 illustrates the on and off states of the transistors in figure 1 in response to logical high or low inputs corresponding to 1 or 0, respectively, at inputs IN1 and IN2.

Figures 3 and 4 illustrate voltage vs. time plots for various inputs to a computer simulation of the circuit shown schematically in figure 1.

Figure 5 illustrates a plot of rise/fall time vs. fanout for a computer simulation of the circuit of figure 1.

Figure 6a illustrates a plot of delay vs. fanout for the computer simulation mentioned above with respect to figure 5.

Figure 6b is a chart illustrating the effect of transistor sizing on circuit delay and through current.

Figure 7 is a schematic drawing which illustrates a second preferred embodiment of the invention.

Figure 8 illustrates the on and off states of the transistors in figure 7 in response to logical high or low inputs corresponding to 1 or 0, respectively, at inputs IN1 and IN2.

Figures 9 and 10 illustrate voltage vs. time plots for various inputs to a computer simulation of the circuit shown schematically in figure 7.

Figure 11 illustrates a plod of rise/fall time vs. fanout for a computer simulation of the logic circuit incorporating the second embodiment of the invention.

Figure 12a illustrates a plot of delay vs. fanout for the computer simulation mentioned above with respect to figure 11.

Figure 12b is a chart, pertaining to the second embodiment of the invention, which illustrates the effect of transistor sizing on delay and through current.

Figure 13 illustrates a schematic drawing of a third preferred embodiment of the invention.

Figure 14 illustrates the on and off states of the transistors in figure 13 in response to logical high or low inputs corresponding to 1 or 0, respectively, at inputs IN1 and IN2.

Figures 15 and 16 illustrate voltage vs. time plots for various inputs to a computer simulation of the circuit shown schematically in figure 7.

Figure 17 illustrates a plot of rise/fall time vs. fanout for a computer simulation of the logic circuit incorporating the third embodiment of the invention.

Figure 18a illustrates a plot of delay vs. fanout for the computer simulation mentioned above with respect to figure 17.

Figure 18b illustrates a chart of transistor sizing and its effect upon circuit delay and through current.

Figure 19 illustrates a schematic drawing of a fourth preferred embodiment of the invention.

Figure 20 is a chart which illustrates transistor sizing effects upon circuit delay and cough current

Figures 21 and 22 are schematic drawings of fifth and sixth preferred embodiments, respectively, of the invention.

### DETAILED DESCRIPTION OF THE INVENTION

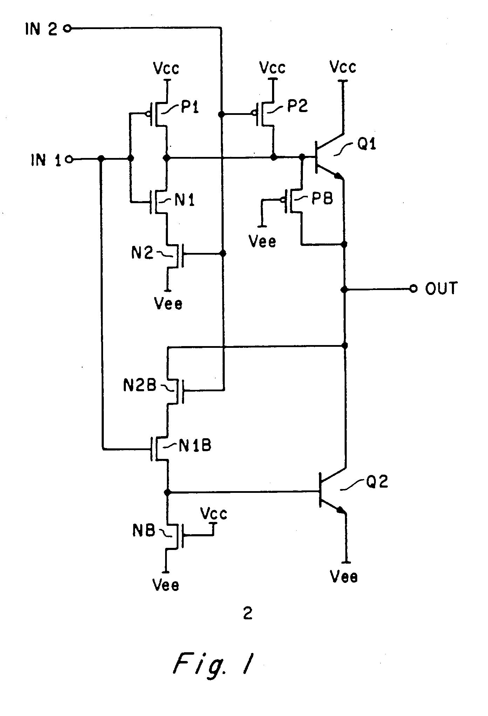

Figure 1 illustrates a schematic drawing of a first preferred embodiment of the invention. In a NAND gate logic circuit generally designated by numeral 2, a first pull-up device comprising n-type bipolar transistor Q1 is coupled to output OUT. A second pull-up device comprising p-channel transistors P1 and P2 are connected to the base of transistor Q1 by their drains. The sources of transistors P1 and P2 as well as the collector of transistor Q1 is connected to supply voltage Vcc. P-channel transistor PB is connected to and between the base and emitter of transistor Q1 with its gate connected to voltage Vee. Alternatively, a switch can be substituted for transistor PB with its operation controlled by output OUT. For exmaple, this switch may comprise a MOS transistor, a n-channel transistor, a p-channel transistor, a plurality of n-channel and/or p-channel transistors, a bipolar transistor or a plurality of bipolar transistors or a combination of the above. Vee throughout the description of the invention represents circuit ground. However, other values for Vee are contemplated and are possible. N-channel transistor NB and a first pull-down device comprising n-type bipolar transistor Q2 are coupled to the output of circuit 2. A switch comprising n-channel transistors N1B and N2B connected together are connected between circuit output 2 and transistors NB and Q2. N-channel transistors N1 and N2 are connected between the circuit inputs at IN1 and IN2 and are coupled to the transistors of the first and second pull-up devices.

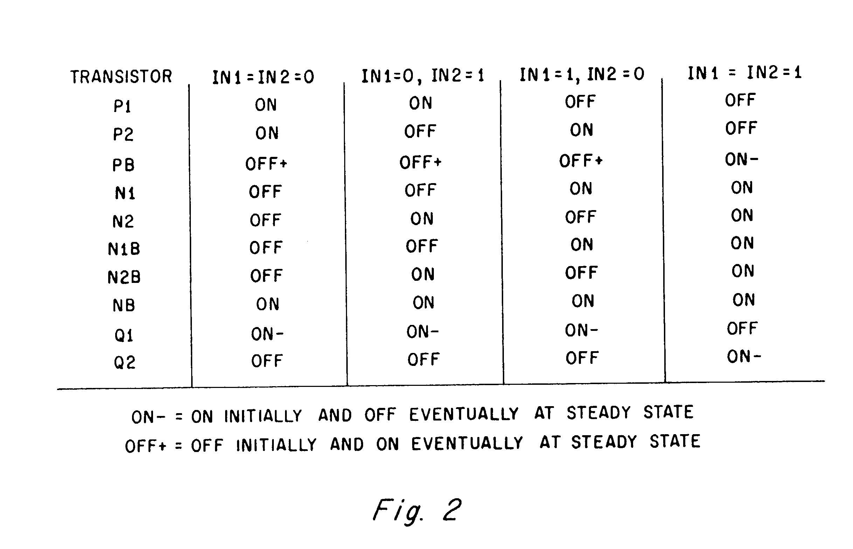

Figure 2 illustrates the on and off states of the transistors in figure 1 in response to logical high or low inputs corresponding to 1 or 0 respectively at inputs IN1 and IN2. A plus sign directly after OFF in figure 2 indicates that a transistor is off initially and will eventually turn on at steady state. A minus sign directly after ON indicates that a transistor is initially on and will eventually turn off at steady state.

In operation, with low inputs at IN1 and IN2 (IN1 = IN2 = 0), Both transistors P1 and P2 are on and provide base current to transistor Q1 in order to pull the circuit output OUT to a voltage of VCC - VBE (VBE represents the base-emitter junction drop of transistor Q1). Transistor PB will eventually pull output OUT to VCC and thus turn transistor Q1 off. Note, that in order to turn on transistor PB, that its gate to source voltage must be lower than an associated threshold voltage. This gate to source voltage is dependent upon the output voltage at output OUT. With input IN1 low and IN2 high (IN1 = 0, IN2 = 1), transistor P1 is on and provides base current to transistor Q1 in order to pull output OUT to a voltage of VCC - VBE. As with the case before, transistor PB eventually will pull the output to VCC and turn Q1 off. An input having IN1 high and IN2 low (IN1 = 1, IN2 = 0), will produce a similar result as with the case having IN1 low and IN2 high (IN1 = 0, IN2 = 1) except that transistor P2 is on and transistor P1 is off. With both inputs high and assuming the initial output voltage is VCC, transistors N1B and N2B are on to provide base current from output OUT to transistor Q2. Transistor Q2 will pull the output down to VBE. At the same time, transistors N1, N2 and PB will discharge the base of transistor Q1 to turn transistor Q1 off. Transistors N1B, N2B and NB will pull output OUT all the way down to ground and turn transistor Q2 off.

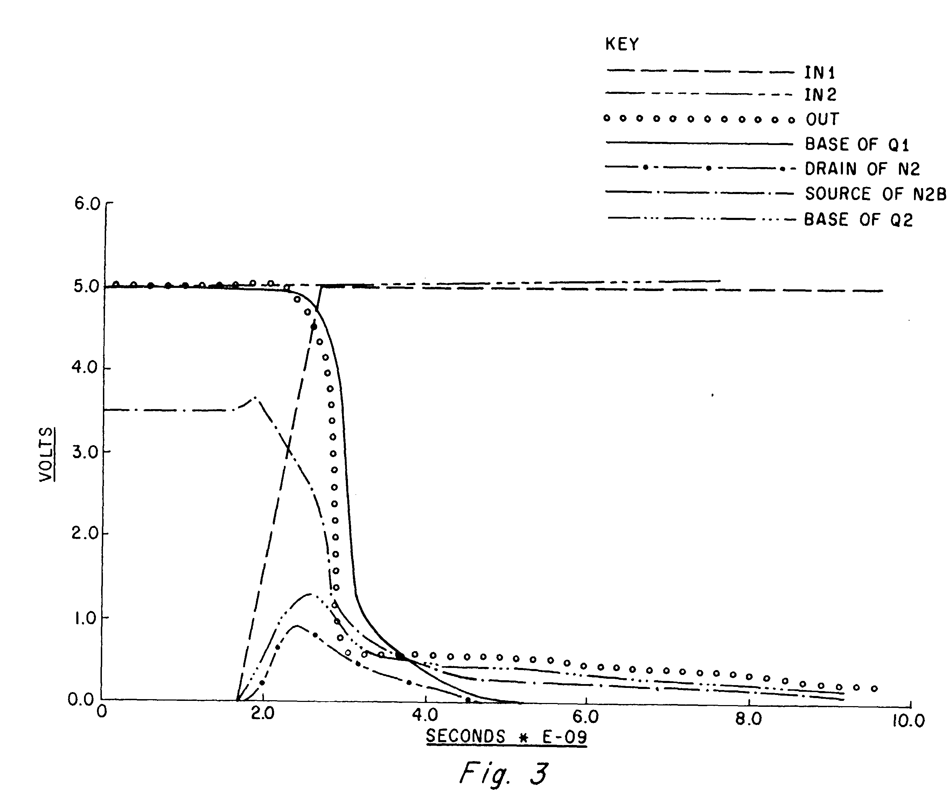

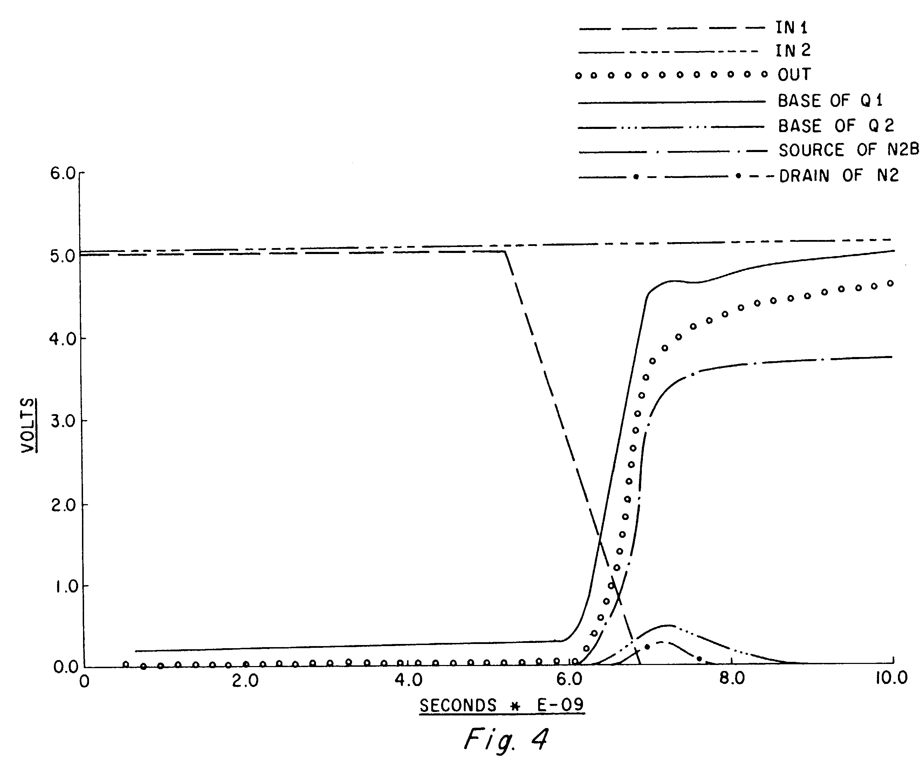

Figures 3 and 4 illustrate voltage vs. time plots for various inputs to a computer simulation of the circuit shown schematically in figure 1. Most of the through current (defined as the current from Vcc to circuit ground, which, as stated previously in all the drawings pertaining to the invention, is shown as voltage Vee, although voltages other than circuit ground may be used for Vee) between bipolar transistors Q1 and Q2 occur at the output falling edge. Through current is synonymous with leakage current. This Q1,Q2 through current is due to the relatively slow turn off of transistor Q1. The placement of transistor PB between the base and emitter of transistor Q1 helps drain transistor Q1's base charge through transistor Q2 and the paths through transistors N2B and N1B initially. Transistors N1 and N2 will continue to drain the remaining base charge when the output falls below the threshold voltage of transistor PB. The larger transistor PB is in size, the faster transistor Q1 will turn off. On the other hand, a larger transistor PB will decrease transistor Q1's base current and thus slow down output OUT's charging time. Transistor Q2, which is turned on during the output falling edge, plays an important role in draining transistor Q1's base charge through transistor PB. Transistor NB is intentionally made small in order to increase the base current to transistor Q2. Thus, the discharge path through transistors N2B, N1B and NB is not a very significant one. Transistors N1 and N2 need not be large since they discharge the remaining charge in the base of transistor Q1 and make sure Q1 is off. Minimum sizing for transistors N1 and N2 is sufficient. Transistor Q1's base voltage should be kept falling as fast as output OUT's voltage in order to prevent transistor Q1 from turning on during a falling edge of output OUT, as shown in figure 3. Transistor PB, in effect, keeps the base and emitter voltages of transistor Q1 close so that transistor Q1 will not be turned on during the time output OUT is being pulled down in voltage. In the output rising case, as shown in Figure 4, the base of transistor Q1 and output OUT's voltages are initially very close to ground potential. Transistor PB will not turn on until the base of Q1 is charged up, thereby allowing more current to flow into the base of Q1 instead of to output OUT. Once transistor PB is on, transistor Q1's emitter current will be weakened due to the reduced base current. The rate of the rising voltage at output OUT will be slowed. The point where the slowing down effect occurs can be adjusted by sizing transistor PB as discussed above. However, the size of transistor PB for different types of functions (eg. NAND vs. NOR) needs to be chosen correctly for optimal performance. In other words, the transistor P1 or transistor P2 to transistor PB ratio as well as bipolar sizing are important parameters to determine the overall performance of the logic circuit. Tradeoffs can be made between the transistor sizes of N1 or N2 and PB. The sizes of transistors N1 and N2 can be increased to drain the base charge of transistor Q1 better. Hence, through manipulation of the sizes of transistors N1 and N2, the size of transistor PB can be reduced. Note that the circuit in figure 1 is constructed in such a way that input IN1's signal arrives late. The voltage input IN2 should settle before the voltage at IN1 in order to give maximum performance for the circuit. Note that input IN1 is connected to the n-channel transistors which are closest to the bipolar bases. This configuration places input IN1 just one n-channel transistor away from discharging transistor Q1 or from providing base current to transistor Q2.

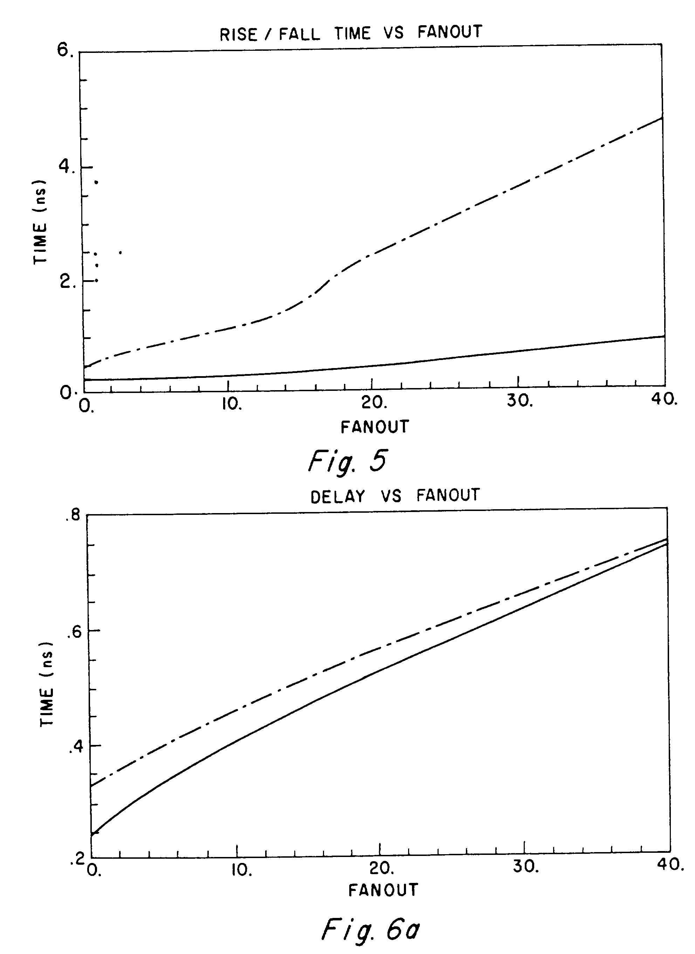

Figure 5 illustrates a plot of rise/fall time vs. fanout for a computer simulation of the circuit of figure 1. The dashed line represents the rise time of the output vs. fanout of the circuit, whereas the solid line represents the fall time of the output vs. fanout of the circuit.

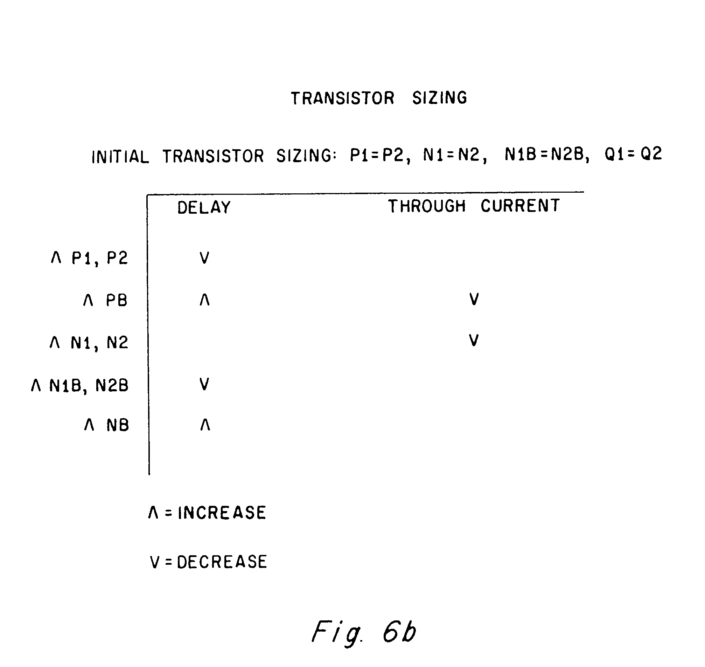

Figure 6a illustrates a plot of delay vs. fanout for the computer simulation mentioned above with respect to figure 5. The dashed line shows the rising delay time of the output vs. fanout for the circuit while the solid line shows the falling delay time of the output vs. fanout for the circuit.

Figure 6b is a chart illustrating the effect of transistor sizing on circuit delay and through current. Note that it is desirable to eliminate or minimize through current since it results in wasted energy.

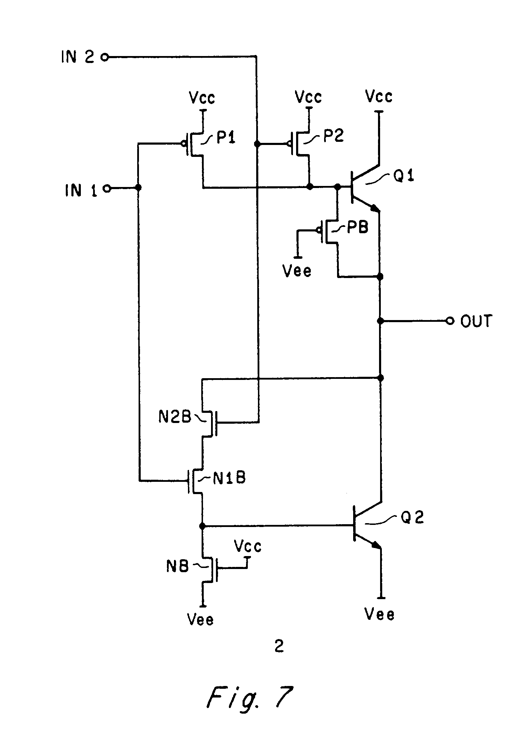

Figure 7 is a schematic drawing which illustrates a second preferred embodiment of the invention. This figure is the same as that shown in figure 1 with the exception that transistors N1 and N2 have been removed.

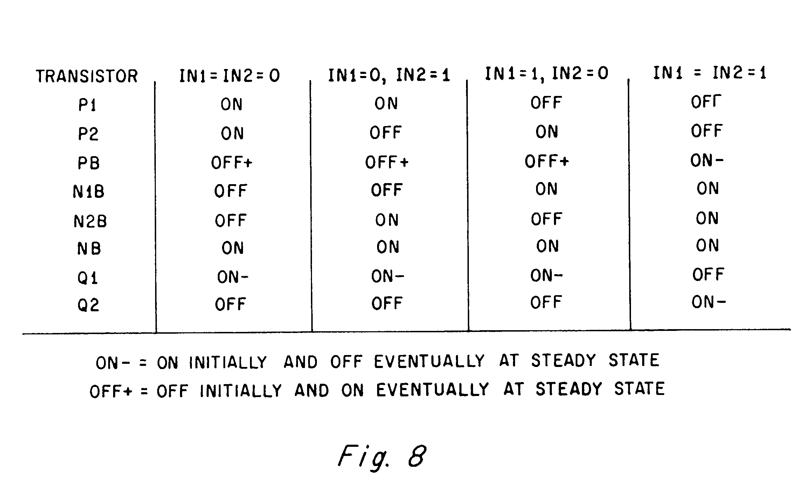

Figure 8 illustrates the on and off states of the transistors in figure 7 in response to logical high or low inputs corresponding to 1 or 0 respectively at inputs IN1 and IN2. A plus sign directly after OFF in figure 7 indicates that a transistor is off initially and will eventually turn on at steady state. A minus sign directly after ON indicates that a transistor is initially on and will eventually turn off at steady state.

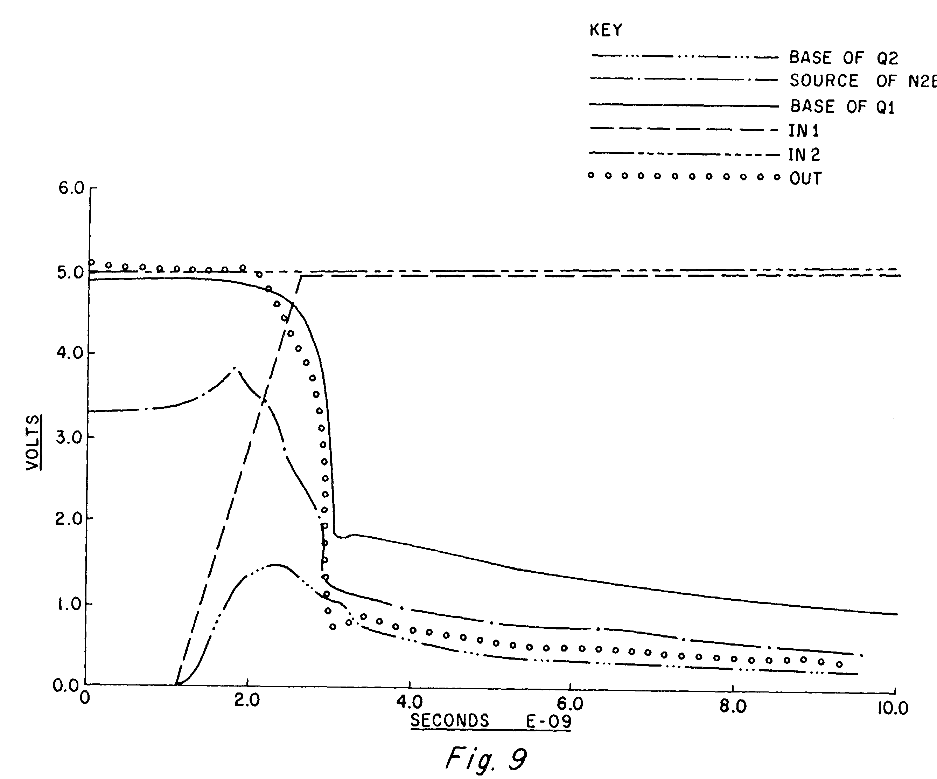

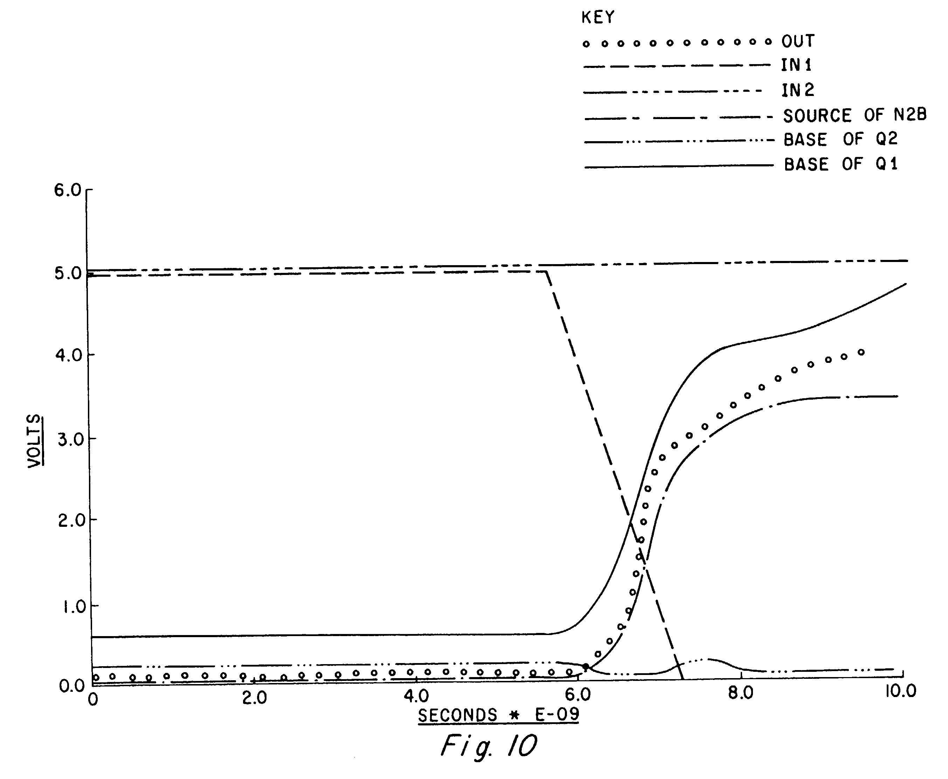

Figures 9 and 10 illustrate voltage vs. time plots for various inputs to a computer simulation of the circuit shown schematically in figure 7.

With reference to figures 7, 8, 9 and 10, it can be seen that the operation of the second preferred embodiment of the invention is similar to the first preferred embodiment of the invention. However, the task of turning off transistor Q1 during the output OUT's falling edge is dependent generally on transistor PB alone. The effectiveness of transistor PB turning off transistor Q1 decreases as output OUT's voltage drops. This second embodiment of the invention is not as immune to noise as the first embodiment of the invention because there is no direct path from the base of transistor Q1 to circuit ground to hold transistor Q1 at an off state. However, note that this second embodiment of the invention economizes the logic circuit by not requiring at least two transistors in comparison with the first embodiment of the invention.

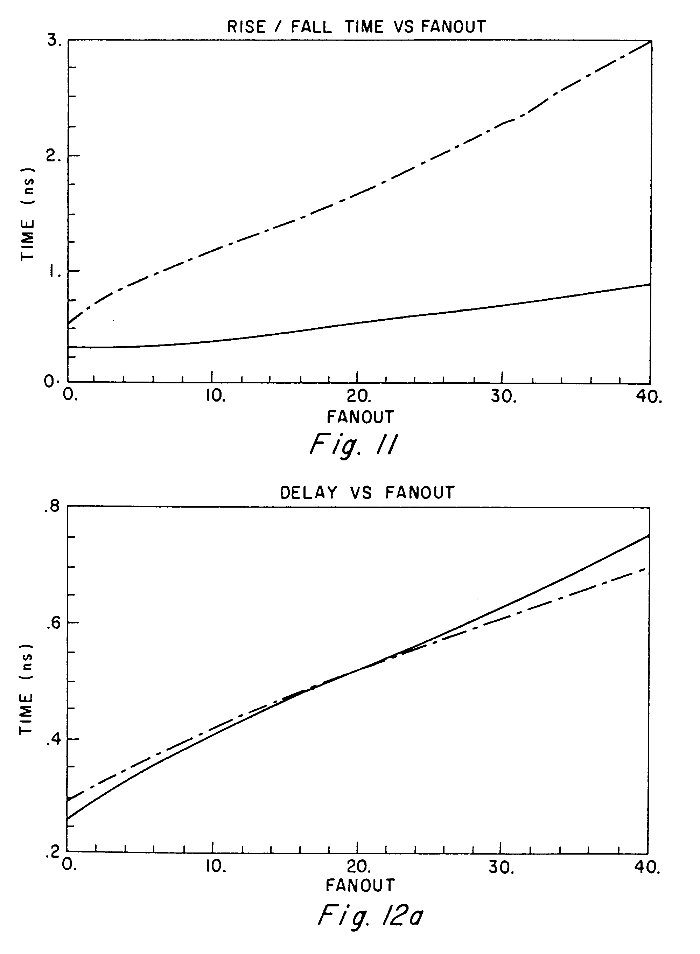

Figure 11 illustrates a plot of rise/fall time vs. fanout for a computer simulation of the logic circuit incorporating the second embodiment of the invention. The dashed line represents the rise time of the output vs. fanout of the circuit, whereas the solid line represents the fall time of the output vs. fanout of the circuit.

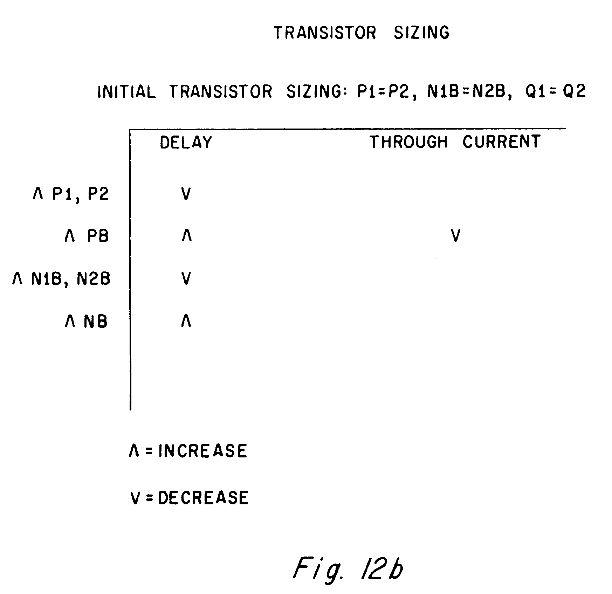

Figure 12a illustrates a plot of delay vs. fanout for the computer simulation mentioned above with respect to figure 11 . The dashed line shows the rising delay time of the output vs. fanout for the circuit while the solid line shows the falling delay time of the output vs. fanout for the circuit.

Figure 12b is a chart, pertaining to the second embodiment of the invention, which illustrates the effect of transistor sizing on delay and through current.

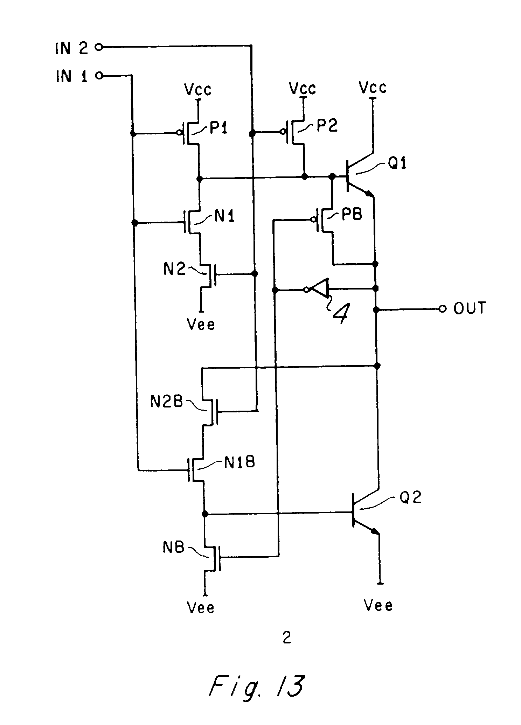

Figure 13 illustrates a schematic drawing of a third embodiment of the invention. This embodiment of the invention is the same as the first embodiment of the invention with the exception that inverter 4 has been added and the gates of transistors NB and PB are no longer hardwired to power rails. Inverter 4 is connected to add between the gate and drain of transistor PB. The gates of transistor NB and PB are connected together.

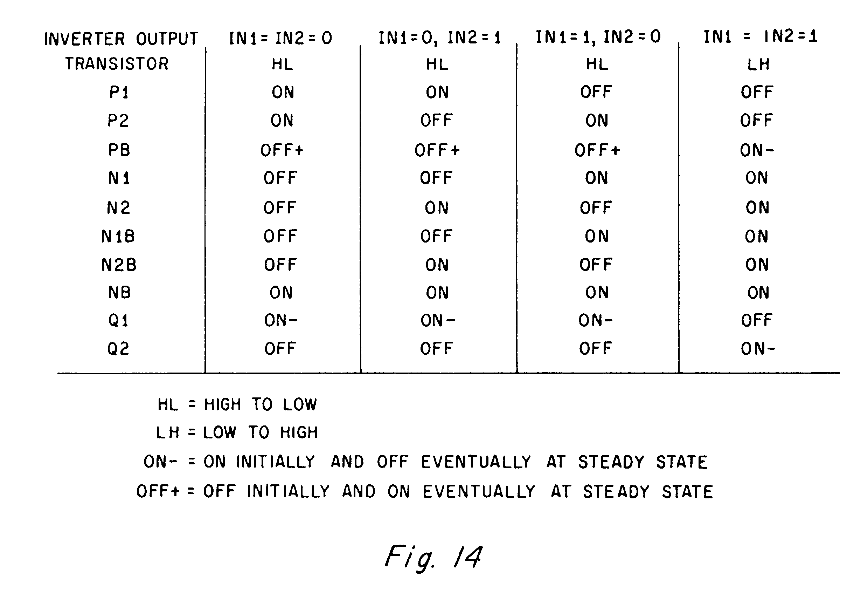

Figure 14 illustrates the on and off states of the transistors in figure 13 in response to logical high or low inputs corresponding to 1 or 0 respectively at inputs IN1 and IN2. A plus sign directly after OFF in Figure 2 indicates that a transistor is off initially and will eventually turn on at steady state. A minus sign directly after ON indicates that a transistor is initially on and will eventually turn off at steady state. HL after the inverter output represents a transition from high to low on the inverter output while LH after the inverter output represents a transition from low to high on the inverter output.

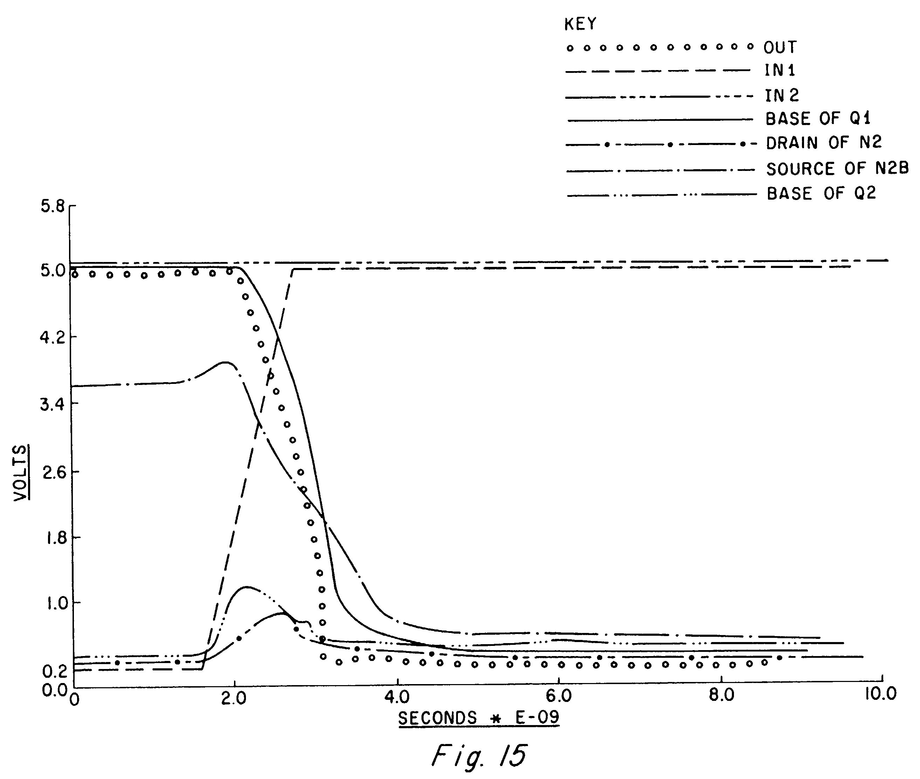

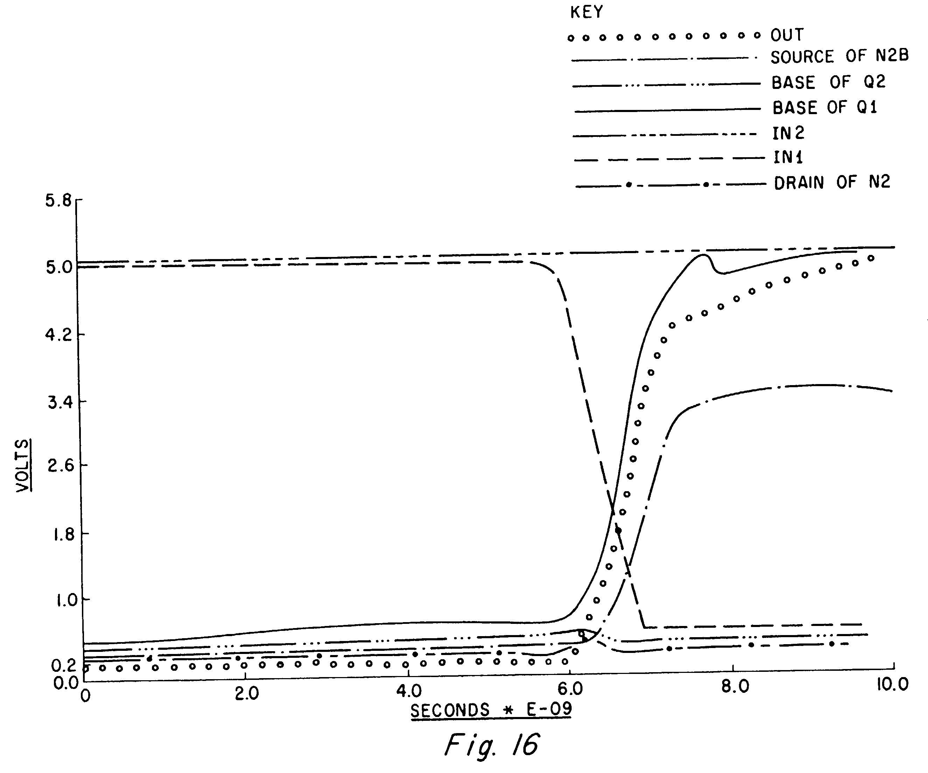

Figures 15 and 16 illustrate voltage vs. time plots for various inputs to a computer simulation of the circuit shown schematically in figure 7.

With reference to figures 13, 14, 15 and 16 it can be seen that the operation of this third preferred embodiment of the invention is similar to the first embodiment of the invention. However, operation of of transistors PB and NB are now controlled by inverter 4. Inverter 4 can be small in size and is controlled by output OUT. Inverter 4 will not turn transistor PB on until output OUT gets above inverter 4's input threshold voltage. This allows more base current flow into transistor Q1 during output OUT's rising edge. Turning transistor PB on later also moves the knee of the output rising edge in comparison with the second embodiment (see figure 16 and compare with figure 10) to a higher voltage because transistor Q1 has been turned on longer in order to charge up output OUT. Similarly, inverter 4 keeps transistor NB off initially while pulling down output OUT in voltage. This translates into more base current to the base of transistor Q2. Eventually, output OUT drops in voltage below the inverter input threshold voltage. Transistor NB is then turned on and pulls output OUT all the way to circuit ground. Thus rail-to-rail output switching is provided with minimized base current loss due to the level restoring characteristics of transistors PB and NB.

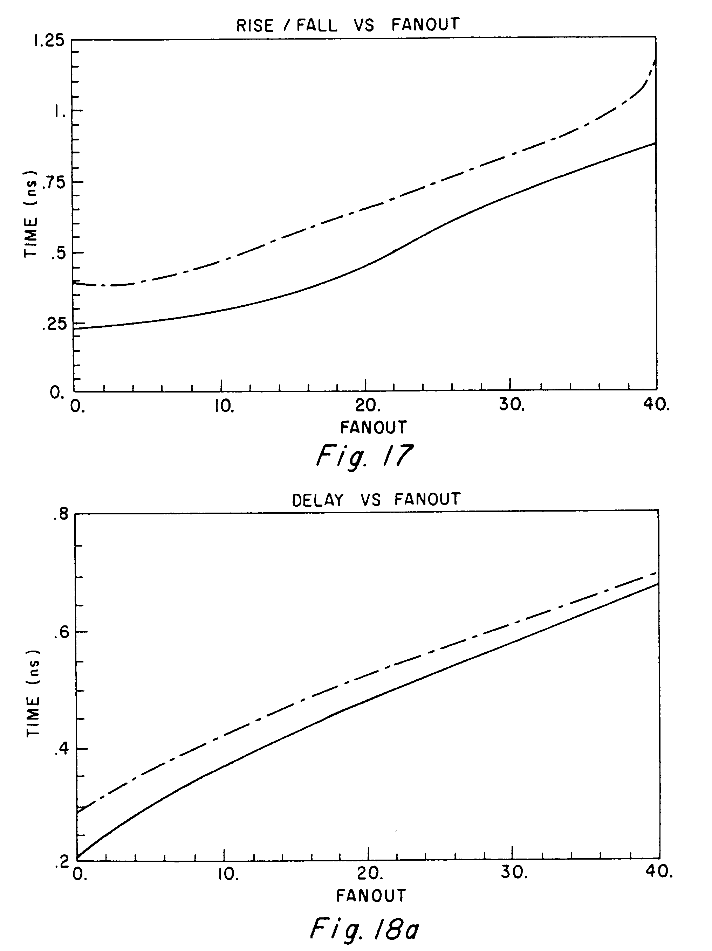

Figure 17 illustrates a plot of rise/fall time vs. fanout for a computer simulation of the logic circuit incorporating the third embodiment of the invention. The dashed line represents the rise time of the output vs. fanout of the circuit, whereas the solid line represents the fall time of the output vs. fanout of the circuit.

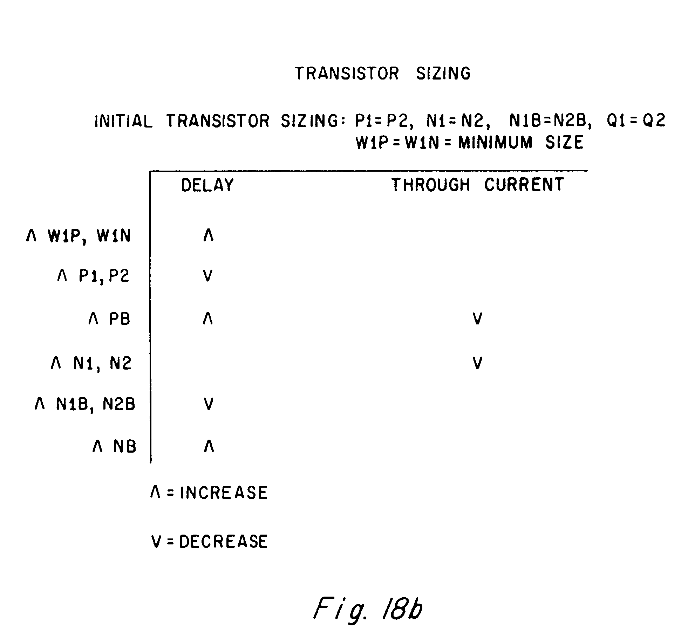

Figure 18a illustrates a plot of delay vs. fanout of the computer simulation mentioned above with respect to figure 17. The dashed line shows the rising delay time of the output vs. fanout for the circuit while the solid line shows the falling delay time of the output vs. fanout for the circuit.

Figure 18b illustrates a chart of transistor sizing and its effect upon circuit delay and through current. WIP and WIN represent the sizes of p-channel and n-channel transistors respectively within inverter 4 of figure 13.

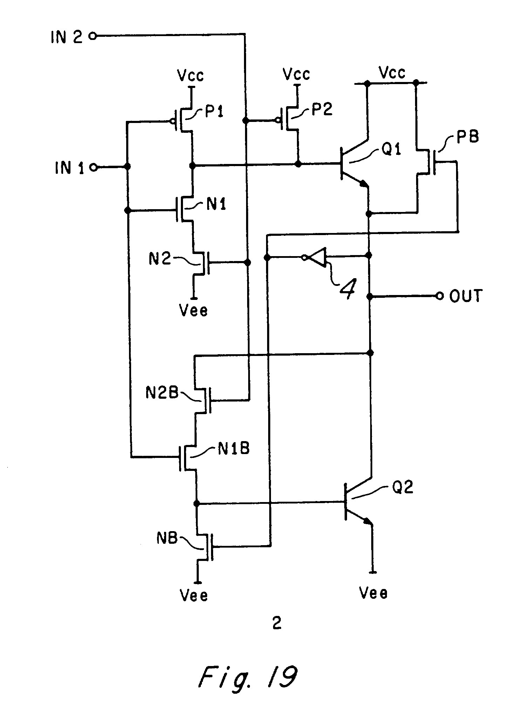

Figure 19 illustrates a schematic drawing of a fourth preferred embodiment of the invention. This embodiment of the invention is the same as the third embodiment of the invention with the exception that the source and drain of transistor PB is connected to and between Vcc and output OUT. This embodiment of the invention may be faster than the third embodiment of the invention depending upon the series resistance of transistors P2 plus PB. Additionally, notice that there is now no base current drain away from transistor Q1 through transistor PB while charging output OUT through Q1. Unlike that shown in figure 16 with respect to the third embodiment of the invention, the knee of the output rising waveform occurs at approximately Vcc-Vbe since there is no substantial circuit slow down by transistor PB. On the other hand, transistors N1 and N2 need to be sized carefully to turn transistor Q1 off while discharging output OUT to prevent excessive crowbar current.

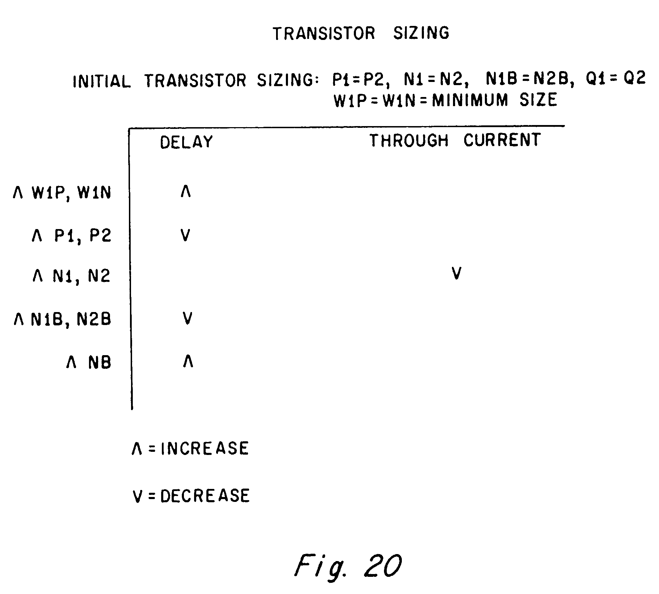

Figure 20 is a chart which illustrates transistor sizing effects upon circuit delay and through current.

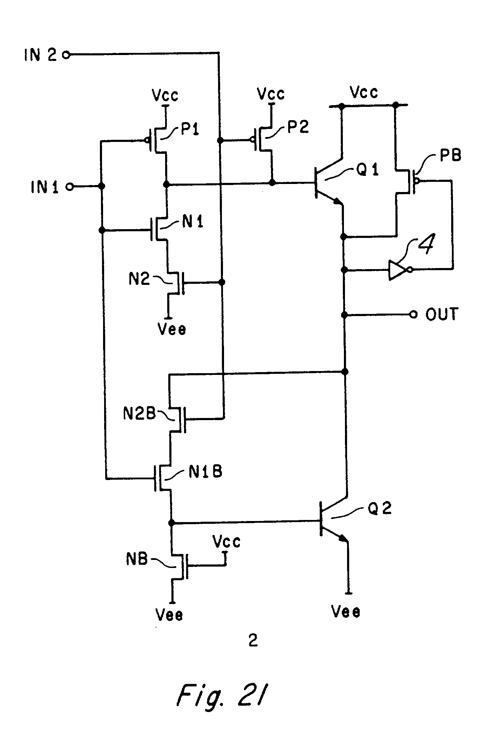

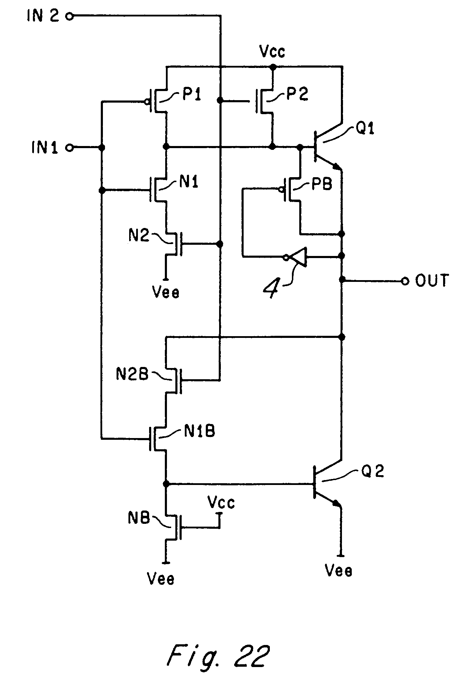

Figures 21 and 22 are schematic drawings which illustrate fifth and sixth preferred embodiments, respectively, of the invention. Figure 21 is the same as figure 19 with the exception that the gate of transistor NB is tied to voltage Vcc. Figure 22 is the same as figure 13 with the exception that the gate of transistor NB is likewise tied to voltage Vcc. Thus, for both of these embodiments transistor NB will be turned on all of the time. A DC (direct current) path between the base of transistor Q2 and Vee (Vee before was indicated as having a value of circuit ground, although other voltages are possible) is established. These embodiments do not let the base of transistor Q2 float. Furthermore, these embodiments keep the base of transistor Q2 very close to circuit ground rather than Vbe. Therefore the chance of transistor Q2 misfiring when coupling from other activities in the circuit to transistor Q2's base is reduced.

It is to be further understood that numerous changes in the details of the embodiments of the invention, and additional embodiments of the invention, will be apparent to and may be made by persons of ordinary skill in the art having reference to this description. For instance, p-type bipolar transistors may be substituted for n-type transistors. Furthermore, p-channel transistors may be substituted for n-channel transistors and vice-versa. Additionally note that NAND gate logic circuits have been shown in the drawings simply because all logic expressions can be implemented strictly with NAND or NOR gates. Those circuits shown can be easily adapted to perform NOR, OR, and AND logic functions.

## Claims

1. A circuit comprising:
a first bipolar transistor (Q1) having a collector connected to a first reference potential (Vcc), a base and an emitter connected to an output terminal (OUT);
a second bipolar transistor (Q2) having a collector connected to said output terminal (OUT), a base and an emitter connected to a second reference potential (Vee);
a first field effect transistor (P1) having a first current handling terminal connected to said first reference potential (Vcc), a second current handling terminal connected to said base of said first bipolar transistor (Q1) and having a gate connected to an input terminal (IN1);
a second field effect transistor (N1B) having a gate connected to said input terminal (IN1) and first and second current handling terminals interposed between said output terminal (OUT) and said base of said second bipolar transistor;
a third field effect transistor (PB) having a first current handling terminal connected to said base of said first bipolar transistor, a second current handling terminal connected to said output terminal (OUT) and a gate characterized in that said gate of said third field effect transistor (PB) is connected to said second reference potential (Vee).

2. A circuit comprising:
a first bipolar transistor (Q1) having a collector connected to a first reference potential (Vcc), a base and an emitter connected to an output terminal (OUT);
a second bipolar transistor (Q2) having a collector connected to said output terminal (OUT), a base and an emitter connected to a second reference potential (Vee);
a first field effect transistor (P1) having a first current handling terminal connected to said first reference potential (Vcc), a second current handling terminal connected to said base of said first bipolar transistor (Q1) and having a gate connected to an input terminal (IN1);
a second field effect transistor (N1B) having a gate connected to said input terminal (IN1) and first and second current handling terminals interposed between said output terminal (OUT) and said base of said second bipolar transistor (Q2);
a third field effect transistor (PB) having a first current handling terminal connected to said base of said first bipolar transistor (Q1) a second current handling terminal connected to said output terminal (OUT) and a gate;
characterized in that said circuit further comprises:
an inverter (4) having an input connected to said output terminal (OUT) and an output connected to said gate of said third field effect transistor (PB).

3. A circuit according to claim 1 wherein the size of the third field effect transistor (PB) relative to the size of at least the first field effect transistor (P1) is such as to optimise the charging and discharging of the base of the first bipolar transistor (Q1).

4. A circuit according to any one of claims 1, 2 and 3 further comprising a second input terminal (IN2),
a fourth field effect transistor (P2) having a first current handling terminal connected to said first reference potential (Vee), a second current handling terminal connected to said base of said first bipolar transistor (Q1) and having a gate connected to said second input terminal (IN2); and
a fifth field effect transistor (N2B) having a gate connected to said second input terminal (IN2) and first and second current handling terminals connected in a series path with the first and second current handling terminals of said second field effect transistor (N1B) between said output terminal (OUT) and the base of said second bipolar transistor (Q2).

5. A circuit according to claim 4 further comprising sixth and seventh field effect transistors (N1,N2) having their gates respectively connected to said first-mentioned and second input terminals (IN2,IN2) and their first and second current handling terminals connected in a series path from the base of said first bipolar transistor (Q1) to said second reference potential (Vee).

6. A circuit according to any one of the preceding claims further comprising an eighth field effect transistor (NB) having a first current handling terminal connected to the base of the second bipolar transistor (Q2), a second current handling terminal connected to said second reference potential (Vee) and a gate connected to said first reference potential (Vcc).

7. A circuit according to claim 2 comprising a further field effect transistor (NB) having a first current handling terminal connected to the base of said second bipolar transistor (Q2), a second current handling terminal connected to said second reference potential (Vee) and a gate connected to said output of said inverter (4).

## Patentansprüche

1. Schaltung umfassend:
einen ersten Bipolartransistor (Q1) mit einem Kollektor, der mit einem ersten Referenzpotential (Vcc) verbunden ist, einer Basis und einem Emitter, der mit einem Ausgangsanschluß (OUT) verbunden ist;
einen zweiten Bipolartransistor (Q2) mit einem Kollektor, der mit dem Ausgangsanschluß (OUT) verbunden ist, einer Basis und einem Emitter, der mit einem zweiten Referenzpotential (Vee) verbunden ist;
einen ersten Feldeffekttransistor (P1) mit einem ersten stromführenden Anschluß, der mit dem ersten Referenzpotential (Vcc) verbunden ist, einem zweiten stromführenden Anschluß, der mit der Basis des ersten Bipolartransistors (Q1) verbunden ist, und einem Gateanschluß, der mit einem Eingangsanschluß (IN1) verbunden ist;
einen zweiten Feldeffekttransistor (N1B) mit einem Gateanschluß, der mit dem Eingangsanschluß (IN1) verbunden ist, sowie einem ersten stromführenden Anschluß und einem zweiten stromführenden Anschluß, die zwischen den Ausgangsanschluß (OUT) und die Basis des zweiten Bipolartransistors geschaltet sind;
einen dritten Feldeffekttransistor (PB) mit einem ersten stromführenden Anschluß, der mit der Basis des ersten Bipolartransistors verbunden ist, einem zweiten stromführenden Anschluß, der mit dem Ausgangsanschluß (OUT) verbunden ist, und einem Gateanschluß,
dadurch gekennzeichnet, daß der Gateanschluß des dritten Feldeffekttransistors (PB) mit dem zweiten Referenzpotential (Vee) verbunden ist.

2. Schaltung umfassend:
einen ersten Bipolartransistor (Q1) mit einem Kollektor, der mit einem ersten Referenzpotential (Vcc) verbunden ist, einer Basis und einem Emitter, der mit einem Ausgangsanschluß (OUT) verbunden ist;
einen zweiten Bipolartransistor (Q2) mit einem Kollektor, der mit dem Ausgangsanschluß (OUT) verbunden ist, einer Basis und einem Emitter, der mit einem zweiten Referenzpotential (Vee) verbunden ist;
einen ersten Feldeffekttransistor (P1) mit einem ersten stromführenden Anschluß, der mit dem ersten Referenzpotential (Vcc) verbunden ist, einem zweiten stromführenden Anschluß, der mit der Basis des ersten Bipolartransistors (Q1) verbunden ist, und einem Gateanschluß, der mit einem Eingangsanschluß (IN1) verbunden ist;
einen zweiten Feldeffekttransistor (N1B) mit einem Gateanschluß, der mit dem Eingangsanschluß (IN1) verbunden ist, und einem ersten stromführenden Anschluß und einem zweiten stromführenden Anschluß, die zwischen den Ausgangsanschluß (OUT) und die Basis des zweiten Bipolartransistors (Q2) geschaltet sind;
einen dritten Feldeffekttransistor (PB) mit einem ersten stromführenden Anschluß, der mit der Basis des ersten Bipolartransistors (Q1) verbunden ist, einem zweiten stromführenden Anschluß, der mit dem Ausgangsanschluß (OUT) verbunden ist, und einem Gateanschluß;
dadurch gekennzeichnet, daß die Schaltung darüber hinaus umfaßt:
einen Inverter (4) mit einem Eingang, der mit dem Ausgangsanschluß (OUT) verbunden ist, und einem Ausgang, der mit dem Gateanschluß des dritten Feldeffekttransistors (PB) verbunden ist.

3. Schaltung nach Anspruch 1, bei der die Bemessung des dritten Feldeffekttransistors (PB) relativ zur Bemessung wenigstens des ersten Feldeffekttransistors (P1) so ist, daß das Laden und Entladen der Basis des ersten Bipolartransistors (Q1) optimiert wird.

4. Schaltung nach einem der Ansprüche 1, 2 und 3 darüber hinaus umfassend einen zweiten Eingangsanschluß (IN2),
einen vierten Feldeffekttransistor (P2) mit einem stromführenden Anschluß, der mit dem ersten Referenzpotential (Vee) verbunden ist, einem zweiten stromführenden Anschluß, der mit der Basis des ersten Bipolartransistors (Q1) verbunden ist, und einem Gateanschluß, der mit dem zweiten Eingangsanschluß (IN2) verbunden ist; und
einen fünften Feldeffekttransistor (N2B) mit einem Gateanschluß, der mit dem zweiten Eingangsanschluß (IN2) verbunden ist, und einem ersten stromführenden Anschluß und einem zweiten stromführenden Anschluß, die in einer Reihenschaltung mit dem ersten stromführenden Anschluß und dem zweiten stromführenden Anschluß des zweiten Feldeffekttransistors (N1B) zwischen den Ausgangsanschluß (OUT) und die Basis des zweiten Bipolartransistors (Q2) geschaltet sind.

5. Schaltung nach Anspruch 4, die darüber hinaus einen sechsten Feldeffekttransistor (N1) und einen siebten Feldeffekttransistor (N2) umfaßt, deren Gateanschlüsse mit dem ersten Eingangsanschluß (IN1) bzw. dem zweiten Eingangsanschluß (IN2) verbunden sind und deren erste stromführende Anschlüsse und deren zweite stromführende Anschlüsse in einer Reihenschaltung von der Basis des ersten Bipolartransistors (Q1) zum zweiten Referenzpotential (Vee) geschaltet sind.

6. Schaltung nach einem der vorhergehenden Ansprüche, die darüber hinaus einen achten Feldeffekttransistor (NB) umfaßt, der einen ersten stromführenden Anschluß, der mit der Basis des zweiten Bipolartransistors (Q2) verbunden ist, einen zweiten stromführenden Anschluß, der mit dem zweiten Referenzpotential (Vee) verbunden ist, und einen Gateanschluß aufweist, der mit dem ersten Referenzpotential (Vcc) verbunden ist.

7. Schaltung nach Anspruch 2, die einen weiteren Feldeffekttransistor (NB) umfaßt, der einen ersten stromführenden Anschluß, der mit der Basis des zweiten Bipolartransistors (Q2) verbunden ist, einen zweiten stromführenden Anschluß, der mit dem zweiten Referenzpotential (Vee) verbunden ist, und einen Gateanschluß aufweist, der mit dem Ausgang des Inverters (4) verbunden ist.

## Revendications

1. Circuit comprenant :
un premier transistor bipolaire (Q1) ayant un collecteur connecté à un premier potentiel de référence (Vcc), une base et un émetteur connectés à une borne de sortie (OUT) ;
un deuxième transistor bipolaire (Q2) ayant un collecteur connecté à ladite borne de sortie (OUT), une base et un émetteur connectés à un deuxième potentiel de référence (Vee) ;
un premier transistor à effet de champ (P1) ayant une première borne de réglage de courant connecté audit premier potentiel de référence (Vcc), une deuxième borne de réglage de courant connectée à ladite base dudit premier transistor bipolaire (Q1) et ayant une grille connectée à une borne d'entrée (IN1) ;
un deuxième transistor à effet de champ (N1B) ayant une grille connectée à ladite première borne d'entrée (IN1) et des première et deuxième bornes de réglage de courant interposées entre ladite borne de sortie (OUT) et ladite base du deuxième transistor bipolaire;
un troisième transistor à effet de champ (PB) ayant une première borne de réglage de courant connectée à ladite base dudit premier transistor bipolaire, une deuxième borne de réglage de courant connectée à ladite borne de sortie (OUT) et une grille, caractérisé en ce que ladite grille du troisième transistor à effet de champ (PB) est connectée audit deuxième potentiel de référence (Vee).

2. Circuit comprenant :
un premier transistor bipolaire (Q1) ayant un collecteur connecté à un premier potentiel de référence (Vcc), une base et un émetteur connectés à une borne de sortie (OUT) ;
un deuxième transistor bipolaire (Q2) ayant un collecteur connecté à ladite borne de sortie (OUT), une base et un émetteur connectés à un deuxième potentiel de référence (Vee) ;
un troisième transistor à effet de champ (P1) ayant une première borne de réglage de courant connectée audit premier potentiel de référence (Vcc), une deuxième borne de réglage de courant connectée à ladite base du premier transistor bipolaire (Q1) et ayant une grille connectée à une borne d'entrée (IN1) ;
un deuxième transistor à effet de champ (N1B) ayant une grille connectée à ladite borne d'entrée (IN1) et des première et deuxième bornes de réglage de courant interposées entre ladite borne de sortie (OUT) et ladite base dudit deuxième transistor bipolaire (Q2) ;
un troisième transistor à effet de champ (PB) ayant une première borne de réglage de courant connectée à ladite base dudit premier transistor bipolaire (Q1), une deuxième borne de réglage de courant connectée à ladite borne de sortie (OUT) et une grille ;
caractérisé en ce que ledit circuit comporte en outre un inverseur (4) ayant une entrée reliée à ladite borne de sortie (OUT) et une sortie connectée à la grille du troisième transistor à effet de champ (PB).

3. Circuit selon la revendication 1, dans lequel la taille du troisième transistor à effet de champ (PB) par rapport à la taille d'au moins le premier transistor à effet de champ (P1) est adaptée pour optimiser la charge et la décharge de la base du premier transistor bipolaire (Q1).

4. Circuit selon l'une des revendications 1, 2 et 3 comportant en outre :
une deuxième borne d'entrée (IN2),
un quatrième transistor à effet de champ (P2) comportant une première borne de réglage de courant connectée audit premier potentiel de référence (Vee), une deuxième borne de réglage de courant connectée à ladite base dudit premier transistor bipolaire (Q1) et ayant une grille connectée à ladite deuxième borne d'entrée (IN2); et
un cinquième transistor à effet de champ (N2B) ayant une grille connectée à ladite deuxième borne d'entrée (IN2) et des première et deuxième bornes de réglage de courant connecté dans un trajet série avec les première et deuxième bornes de réglage de courant dudit deuxième transistor à effet de champ (N1B) entre ladite borne de sortie (OUT) et la base du deuxième transistor bipolaire (Q2).

5. Circuit selon la revendication 4, comportant en outre des sixième et septième transistors à effet de champ (N1,N2) ayant leur grille respectivement connectée auxdites première et deuxième bornes d'entrée (IN1,IN2) et leurs première et deuxième bornes de réglage de courant connectées dans un trajet série à partir de la base dudit premier transistor bipolaire (Q1) au deuxième potentiel de référence (Vee).

6. Circuit selon l'une quelconque des revendications précédentes, comportant en outre un huitième transistor à effet de champ (NB) comportant une première borne de réglage de courant connectée à la base du deuxième transistor bipolaire (Q2), une deuxième borne de réglage de courant connectée audit deuxième potentiel de référence (Vee) et une grille connectée audit premier potentiel de référence (Vcc).

7. Circuit selon la revendication 2, comprenant un transistor à effet de champ supplémentaire (NB) ayant une première borne de réglage de courant connectée à la base dudit deuxième transistor bipolaire (Q2), une deuxième borne de réglage de courant connectée audit deuxième potentiel de référence (Vee) et une grille connectée à la sortie dudit inverseur (4).
